# EUROPEAN PATENT APPLICATION

(11) **EP 2 256 764 A2**
(43) Date of publication of application: **01.12.2010**
(21) Application number: 10163990.4
(22) Date of filing: 27.05.2010
(51) Int. Cl.: H01G 9/20, H01L 51/00

(54) **Dye-sensitized solar cell and organic solvent-free electrolyte for dye-sensitized solar cell**

(30) Priority: 28.05.2009 JP 2009129430
(71) Applicant: TDK Corporation, Tokyo 103-8272 (JP)
(72) Inventor: Murai, Miki, Tokyo 103-8272 (JP)
(74) Representative: Grünecker, Kinkeldey, Stockmair & Schwanhäusser Anwaltssozietät

(57) **Abstract**

Provided are a novel dye-sensitized solar cell (100) using an organic solvent-free electrolyte (31) and capable of exhibiting excellent photoelectric conversion characteristics, and a novel and practical organic solvent-free electrolyte for such a dye-sensitized solar cell.
An organic solvent-free electrolyte containing a conductive carbon material, water, and an inorganic iodine compound is used as an electrolyte for a dye-sensitized solar cell. The organic solvent-free electrolyte is preferably a quasi-solid electrolyte and the conductive carbon material in the organic solvent-free electrolyte has a surface area of preferably from 30 to 300 m²/g.

## Description

### BACKGROUND OF THE INVENTION

### Field of the Invention

The present invention relates to a dye-sensitized solar cell and an organic solvent-free electrolyte for dye-sensitized solar cell.

### Description of the Related Art

In recent days, dye-sensitized solar cells have attracted attentions because they have a high photoelectric conversion efficiency among organic solar cells and can be manufactured at a low cost. The dye-sensitized solar cells each has, as principal constituting elements, a porous metal oxide semiconductor, a sensitizing dye, an electrolyte, and a counter electrode.

It is the common practice to use, as an electrolyte for a dye-sensitized solar cell, that containing an organic solvent (refer to, for example, Japanese Patent Application Laid-Open No. 2007-220412). When an electrolyte containing an organic solvent is used, however, a manufacturing step of the solar cell should be performed under non-aqueous environment, preferably under dehydrated state. This makes the manufacturing step complicated and needs an additional production cost for creating such an environment. In addition to this problem, leakage of the organic solvent from the dye-sensitized solar cell may cause environmental pollution due to evaporation of the organic solvent. Moreover, there is a possibility of it causing fire or explosion. There is therefore an eager demand for the development of a water-based electrolyte and quasi-solidification of an electrolyte. In addition, the dye-sensitized solar cells tend to use platinum as a counter electrode in order to achieve a good cell performance. The platinum is expensive so that there is also a demand for the development of a dye-sensitized solar cell exhibiting a good cell performance without using platinum as a counter electrode.

On the other hand, Japanese Patent Application Laid-Open No. 2002-175841 proposes a quasi-solid electrolyte containing ethylene carbonate, water, iodine, and tetra-n-propyl ammonium iodide. Such a quasi-solid electrolyte still contains an organic solvent such as ethylene carbonate and quasi-solidification of the electrolyte has not been performed sufficiently. In addition, it is presumed to exhibit a good cell performance by using platinum as a counter electrode.

Japanese Patent Application Laid-Open No. 2005-285756 proposes a paste electrolyte containing an alumina hydrate, water, acetic acid, polyethylene glycol, and lithium iodide. Such a paste electrolyte however is not preferred because it contains polyethylene glycol and induces peeling of the sensitizing dye. In addition, it is presumed to exhibit a good cell performance by using platinum as a counter electrode.

Japanese Patent Application Laid-Open Nos. 2003-308889 and 2003-308890 propose an electrolyte not containing an organic solvent, more specifically, an electrolyte containing lithium iodide, iodine, and water. According to these documents, using such an electrolyte can produce an electromotive force of about 0.7 V. This electrolyte is however not in a quasi-solid form and in addition, does not have a sufficient performance as an electrolyte so that it seems impossible to permit dye-sensitized solar cells to exhibit practical photoelectric conversion characteristics when the electrolyte is used therefor.

[Patent Document 1] Japanese Patent Application Laid-Open No. 2007-220412
[Patent Document 2] Japanese Patent Application Laid-Open No. 2002-175841
[Patent Document 3] Japanese Patent Application Laid-Open No. 2005-285756
[Patent Document 4] Japanese Patent Application Laid-Open No. 2003-308889
[Patent Document 5] Japanese Patent Application Laid-Open No. 2003-308890

### SUMMARY OF THE INVENTION

The present invention has been made in view of the above-described problems. An object of the present invention is to provide a novel dye-sensitized solar cell employing an organic solvent-free electrolyte and capable of exhibiting excellent photoelectric conversion characteristics; and a novel and practical organic solvent-free electrolyte for such a dye-sensitized solar cell.

As a result of repeating intensive study, the present inventors have found that an organic solvent-free electrolyte using a conductive carbon material, water, and an inorganic iodine compound in combination can produce excellent photoelectric conversion characteristics without using platinum as a counter electrode, leading to the completion of the invention.

In the present invention, there are thus provided following four aspects (1) to (4):
(1) a dye-sensitized solar cell equipped with a metal oxide electrode having a base and a metal oxide layer disposed on the base, a counter electrode disposed so as to face the metal oxide electrode, and an electrolyte placed between the metal oxide electrode and the counter electrode, wherein the metal oxide layer comprises a sensitizing dye supported thereon , and the electrolyte is an organic solvent-free electrolyte containing a conductive carbon material, water, and an inorganic iodine compound;
(2) the dye-sensitized solar cell as described above in (1), wherein the organic solvent-free electrolyte is a quasi-solid electrolyte;
(3) the dye-sensitized solar cell as described above in (1) or (2) wherein the conductive carbon material in the organic solvent-free electrolyte has a surface area of from 30 to 300 m²/g; and
(4) an organic solvent-free electrolyte for dye-sensitized solar cell containing a conductive carbon material, water, and an inorganic iodine compound.

The present invention makes it possible to realize a novel dye-sensitized solar cell that uses an organic solvent-free electrolyte and therefore can exhibit excellent photoelectric conversion characteristics. It can exhibit excellent photoelectric conversion characteristics without using platinum as a counter electrode so that it enables cost reduction. In addition, a novel and practical water-based electrolyte not containing an organic solvent can be realized and further, quasi-solidification can be realized. The invention can therefore provide dye-sensitized solar cells freed from problems such as leakage of a solvent and environmental pollution, fire or explosion derived therefrom and therefore having improved safety and reliability.

### BRIEF DESCRIPTION OF THE DRAWING

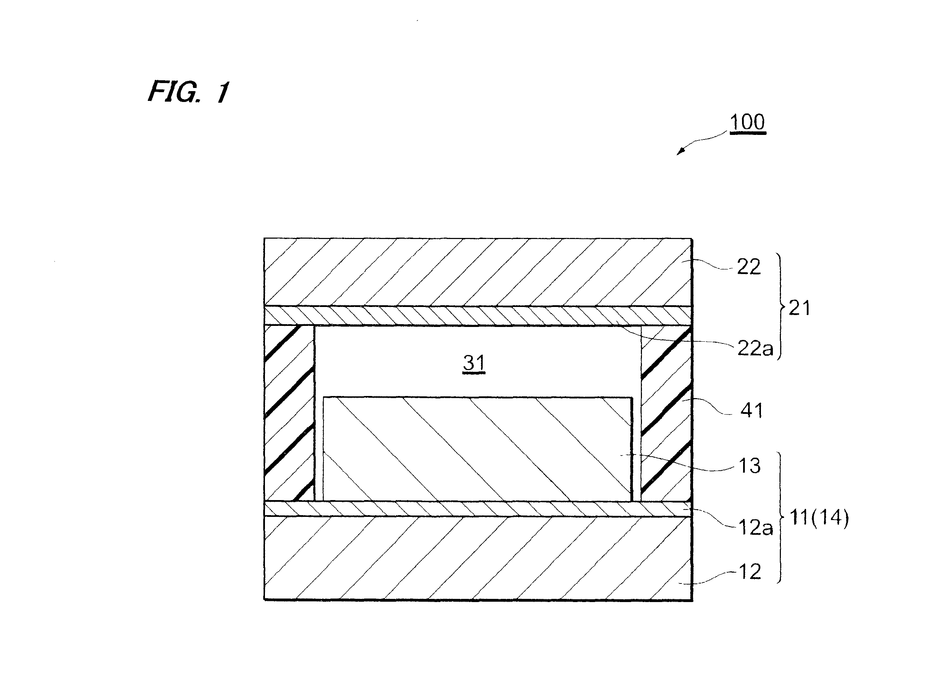

FIG. 1 is a cross-sectional view illustrating a schematic constitution of a dye-sensitized solar cell 100.

### DESCRIPTION OF THE PREFERRED EMBODIMENTS

Embodiments of the present invention will hereinafter be described. It is to be noted that the same element is denoted with the same reference numeral, and overlapping description is omitted. Moreover, positional relations of top, bottom, left, right and the like are based on a positional relation shown in the drawing unless otherwise particularly indicated. Furthermore, a dimensional ratio of the drawing is not limited to a shown ratio. The following embodiments merely illustrate the present invention, and the present invention is not limited only to the embodiments.

FIG. 1 is a schematic view illustrating a schematic constitution of the dye-sensitized solar cell according to the present embodiment.
The dye-sensitized solar cell 100 is equipped with a dye-supported electrode 11 as a working electrode, a counter electrode 21, and an organic solvent-free electrolyte 31 placed between the dye-supported electrode 11 and the counter electrode 21. The dye-supported electrode 11 and the counter electrode 21 are placed opposite to each other via a spacer 41. The organic solvent-free electrolyte 31 is enclosed in a sealed space defined by the dye-supported electrode 11, the counter electrode 21, the spacer 41, and a sealing member not illustrated.

The dye-supported electrode 11 is equipped with a metal oxide electrode 14 having a porous metal oxide layer 13 containing a metal oxide on a conductive surface 12a of a base 12 and comprises a sensitizing dye supported (adsorbed) on the metal oxide layer 13. In other words, the dye-supported electrode 11 of the present embodiment is comprised so that the metal oxide layer 13 having a sensitizing dye supported (adsorbed) thereon, that is, a composite structure having a sensitizing dye supported (adsorbed) on the surface of a metal oxide is stacked on the conductive surface 12a of the base 12.

No particular limitation is imposed on the kind or dimensional shape of the base 12 insofar as it can support at least the metal oxide layer 13. For example, a platelike base or sheet-like base is preferably used. Specific examples of the base include glass substrates, substrates made of plastics such as polyethylene terephthalate, polyethylene, polypropylene, and polystyrene, metal substrates, alloy substrates, and ceramic substrates, and laminates thereof The base 12 has preferably optical transparency, more preferably excellent optical transparency in a visible light range. The base 12 has more preferably flexibility. When the base has flexibility, structures of various shapes can be provided taking advantage of the flexibility.

The conductive surface 12a can be given to the base 12 for example by forming a transparent conducting film such as conductive PET film on the base 12. Alternatively, treatment for giving the conductive surface 12a to the base 12 can be omitted by using the base 12 having conductivity. Specific examples of the transparent conducting film include, but not particularly limited to, indium-tin oxide (ITO), indium-zinc oxide (IZO), SnO₂, and InO₃, and also FTO obtained by doping SnO₂ with fluorine. These transparent conducting films may be used either singly or in combination. No particular limitation is imposed on the formation method of the transparent conducting film and it can be formed in a known manner, for example, deposition, CVD, spraying, spin coating, or immersion. The thickness of the transparent conducting film can be set as needed. The conductive surface 12a of the base 12 may be subjected to appropriate surface modification treatment if necessary. Specific examples of it include, but not particularly limited to, known surface treatments such as degreasing with a surfactant, organic solvent, aqueous alkali solution or the like, mechanical polishing, immersion in an aqueous solution, preliminary electrolysis with an electrolyte solution, washing with water, and drying

The metal oxide layer 13 is a porous semiconductor layer composed mainly of a metal oxide such as TiO₂, ZnO, SnO₂ WO₃, or Nb₂O₅. The metal oxide layer 13 may contain a metal such as titanium, tin, zinc, iron, tungsten, zirconium, strontium, indium, cerium, vanadium, niobium, tantalum, cadmium, lead, antimony or bismuth, or an oxide or chalcogenide thereof. Although no particular limitation is imposed on the thickness of the metal oxide layer 13, it is preferably from 0.05 to 50 µm.

Examples of the method of forming the metal oxide layer 13 include, but not particularly limited to, a method of giving a dispersion liquid of a metal oxide to the conductive surface of the base and then high-temperature sintering the resulting base; a method of giving a paste of a metal oxide to the conductive surface of the base and then carrying out low temperature treatment of the resulting base at from about 50 to 150°C; and a method of causing cathode electrodeposition of a metal-salt-containing electrolyte solution, thereby forming a metal oxide on the conductive surface of the base.

There is no particular limitation imposed on the sensitizing dye to be supported on the metal oxide layer 13 and the dye may be any of water-soluble dyes, water-insoluble dyes and oil-soluble dyes. Depending on the performance which a photoelectric conversion element is required to have, a sensitizing dye having a desired optical absorption band/absorption spectrum can be selected as needed. Specific examples of the sensitizing dye include, but not particularly limited to, xanthene dyes such as eosin-Y, coumarin dyes, triphenylmethane dyes, cyanine dyes, merocyanine dyes, phthalocyanine dyes, naphthalocyanine dyes, porphyrin dyes, and polypyridine metal complex dyes and also ruthenium bipyridium dyes, azo dyes, quinone dyes, quinonimine dyes, quinacridone dyes, squarium dyes, perylene dyes, indigo dyes, oxonol dyes, polymethine dyes, and riboflavin dyes. They may be used either singly or in combination. In order to increase the amount of the dye to be supported, the sensitizing dye preferably has an adsorptive group that interacts with a metal oxide. Specific examples of the adsorptive group include, but not limited to, carboxyl group, sulfonic acid group, and phosphoric acid group.

Examples of the method of causing the sensitizing dye to be supported on the metal oxide layer 13 include a method of immersing the metal oxide layer 13 in a sensitizing-dye-containing solution and a method of coating the metal oxide layer 13 with a sensitizing-dye-containing solution. The solvent of the sensitizing-dye-containing solution to be used here can be selected as needed from known solvents such as water, ethanol solvents, nitrile solvents, and ketone solvents, depending on the solubility or compatibility of the sensitizing dye to be employed.

When the metal oxide layer 13 is formed by cathode electrodeposition, it is possible to form the metal oxide layer 13 having a sensitizing dye supported (adsorbed) thereon at once by using an electrolyte solution containing a metal salt and the sensitizing dye and carrying out formation of the metal oxide layer 13 and supporting of the dye simultaneously. Electrolysis conditions may be set as needed in accordance with a conventional manner, depending on the characteristics of the materials employed. For example, when a metal oxide layer having a dye supported thereon is formed from ZnO and a sensitizing dye, it is preferred to set a reduction electrolyte potential at from about -0.8 to -1.2 V (vs. Ag/AgCl), pH at from about 4 to 9, and a bath temperature of an electrolyte solution at from about 0 to 100°C. It is also preferred that the metal ion concentration in the electrolyte solution is preferably from about 0.5 to 100 mM and the dye concentration in the electrolyte solution is from about 50 to 500 µM. In order to heighten the photoelectric conversion characteristics further, the sensitizing dye may be desorbed once from the metal oxide layer 13 having the sensitizing dye supported thereon and then another sensitizing dye may be re-adsorbed.

The dye-supported electrode 11 (metal oxide electrode 14) may have an intermediate layer between the conductive surface 12a of the base 12 and the metal oxide layer 13. Although no particular limitation is imposed on the material of the intermediate layer, metal oxides similar to those described above in the section of the transparent conducting film 12a are preferred. The intermediate layer can be formed by precipitating or depositing a metal oxide on the conductive surface 12a of the base 12 in a known manner such as deposition, CVD, spraying, spin coating, immersion, or electrodeposition. The intermediate layer has preferably light transparency and more preferably both light transparency and conductivity. Although no particular limitation is imposed on the thickness of the intermediate layer, it is preferably from 0.1 to 5 µm.

The counter electrode 21 is made of a base 22 having a conductive surface 22a and it is disposed so that the conductive surface 22a faces the metal oxide layer 13 of the dye-supported electrode 11. As the base 22 and the conductive surface 22a, known ones similar to the base 12 and the conductive surface 12a described above can be employed as needed. For example, as well as the base 12 having conductivity, the base 12 having thereon a transparent conducting film 12a, and the base 12 having, on a transparent conducting film 12a thereof, a film of a metal such as platinum, gold, silver, copper, aluminum, indium, molybdenum, or titanium, carbon, or a conductive polymer can be used. In the present embodiment, as described above, an organic solvent-free electrolyte capable of producing excellent photoelectric conversion characteristics without using platinum as the counter electrode is used so that superiority to the conventional art becomes evident when a relatively inexpensive counter electrode such as the base 12 having conductivity or the base 12 having thereon the transparent conducting film 12a is used.

The organic solvent-free electrolyte 31 contains a conductive carbon material, water, and an inorganic iodine compound and does not contain an organic solvent. The term "organic solvent" as used herein means an organic compound in liquid form and capable of dispersing therein a conductive carbon material and/or an inorganic iodine compound or capable of dissolving therein a conductive carbon material and/or an inorganic iodine compound wholly or partially. Specific examples of the organic solvent include hexane, benzene, toluene, diethyl ether, chloroform, ethyl acetate, tetrahydrofuran, methylene chloride, acetone, acetonitrile, methoxyacetonitrile, propionitrile, benzonitrile, 3-methoxypropionitrile, N,N-dimethylformamide, dimethylsulfoxide, sulfolan, acetic acid, formic acid, methanol, ethanol, 1-propanol, 2-propanol, 1-butanol, methyl ethyl ketone, ethylene carbonate, propylene carbonate, ethylene glycol monoalkyl ether, propylene glycol monoalkyl ether, polyethylene glycol monoalkyl ether, polypropylene glycol monoalkyl ether, ethylene glycol, propylene glycol, polyethylene glycol, polypropylene glycol, glycerin, dioxane, ethylene glycol dialkyl ether, propylene glycol dialkyl ether, polyethylene glycol dialkyl ether, polypropylene glycol dialkyl ether, γ-butyrolactone, α-methyl-y-butyrolactone, β-methyl-γ-butyrolactone, γ-valerolactone, and 3-methyl-γ-valerolactone.

The term "organic solvent-free" means that the organic solvent is not added when the organic solvent-free electrolyte 31 is prepared and containing it in an amount as small as the content of it in another component such as conductive carbon material, water, and inorganic iodine compound as an inevitable impurity is acceptable. The content of the organic solvent is therefore preferably from 0 to 1 wt.%, more preferably from 0 to 0.5 wt.%, more preferably from 0 to 0.1 wt.%.

The conductive carbon material is a carbon material having conductivity. Specific examples of it include, but not particularly limited to, carbon black, carbon fiber, carbon nanotube, graphite, activated carbon, and fullerene. They may be used either singly or in combination. In consideration of the conductivity and economy, carbon black, carbon fiber, graphite, and carbon nanotube are preferred, with carbon black being more preferred. Specific examples of the carbon black include Ketjen Black, Acetylene Black, and Oil Furnace Black. Although no particular limitation is imposed on the content of the conductive carbon material, it is preferably from 5 to 80 wt.%, more preferably from 10 to 70 wt.%, still more preferably from 15 to 60 wt.% based on the total amount of the organic solvent-free electrolyte 31.

Although no particular limitation is imposed on water insofar as it is industrially usable, water having extremely high purity and called millipore water, pure water, ultrapure water, or the like is preferred. More specifically, water having a total organic carbon content (TOC) of from about 0.05 to 5 mg/L and an electrical conductivity (specific resistance) of from about 5.6 to 1000 µS/m (from about 0.1 to 18 MΩ·cm) is preferred. Although no particular limitation is imposed on a water content, it is preferably from 20 to 95 wt.%, more preferably from 30 to 90 wt.%, still more preferably from 40 to 85 wt.% based on the total amount of the organic solvent-free electrolyte 31.

The inorganic iodine compound functions as a redox agent and specific examples of it include, but not particularly limited to, KI, NaI, I₂, KIO₃, NaIO₄, LiI, NaIO₃, KIO₄, MgI₂, CaI₂, Mg(IO₃)₂, Ca(IO₃)₂, NH₄I, NH₄IO₃, and NH₄IO₄. They may be used either singly or in combination, but using iodine and an iodide (for example, a metal iodide and a quaternary ammonium iodide) in combination is preferred. The content of the inorganic iodine compound is not particularly limited, but is preferably from 1×10⁻⁴ to 1×10⁻² mol/g, more preferably from 1×10⁻³ to 1×10⁻² mol/g, each based on the total amount of the organic solvent-free electrolyte 31.

The organic solvent-free electrolyte 31 is preferably a quasi-solid electrolyte. The term "quasi-solid" as used herein means a concept embracing a solid and a gel-like or clay-like solid having almost no fluidity but capable of deforming when a stress is applied. More specifically, it means a gel-like or clay-like solid that undergoes no change of form under its own weight or undergoes a slight change of form after it is left to stand for a predetermined time. The form of the quasi-solid electrolyte may be any of a solution, a mixture, a dispersion liquid, a suspension, or a colloid solution.

In the organic solvent-free electrolyte 31, the surface area of the conductive carbon material is adjusted to preferably from 30 to 300 m²/g, more preferably from 100 to 250 m²/g, still more preferably from 150 to 200 m²/g. The term "surface area of the conductive carbon material in the organic solvent-free electrolyte 31" as used herein means a value obtained by multiplying the specific surface area (m²/g) of the conductive carbon material by a using rate of the conductive carbon material ((the amount (g) of the conductive carbon material)/(total amount (g) of the organic solvent-free electrolyte 31)). The resulting electrolyte tends to exhibit excellent photoelectric conversion characteristics by controlling the surface area of the conductive carbon material within the above-described range.

The organic solvent-free electrolyte 31 may contain various additives, depending on the performance which it is required to have. As the additive, those ordinarily used for batteries or solar cells can be used as needed. Specific examples include, but not particular limited thereto, p-type conductive polymers such as polyaniline, polyacetylene, polypyrrole, polythiophene, polyphenylene, and polyphenylene vinylene, and derivatives thereof; molten salts available from the combination of a halogen ion and an imidazolium ion, pyridinium ion, or triazolium ion, or a derivative thereof; gelling agents; oil gelling agents; dispersing agents; surfactants; and stabilizers.

The organic solvent-free electrolyte 31 may be prepared in a conventional manner. For example, a uniform quasi-solid electrolyte can be prepared by mixing or kneading the conductive carbon material with water, the inorganic iodine compound, and various additives to be incorporated if necessary.

No particular limitation is imposed on a method of placing the organic solvent-free electrolyte 31 between the dye-supported electrode 11 and the counter electrode 21 and various known methods can be employed for it. Described specifically, it is possible to select a proper one from the methods of application such as gravure coating, roll coating, blade coating, bar coating, spray coating, extrusion coating, dip coating, and spin coating; the dripping method; and the ink jet method. The organic solvent-free electrolyte 31 may be supplied continuously or intermittently. Further, two or more organic solvent-free electrolytes 31 may be supplied.

Preparation of the organic solvent-free electrolyte 31, supplying of the organic solvent-free electrolyte 31 onto the dye-supported electrode 11 and/or counter electrode 21, or preparation of the dye-sensitized solar cell 100 may be performed preferably under reduced pressure and/or under heating. This promotes to fill the organic solvent-free electrolyte 31 more deeply (into the voids of the pores) of the porous metal oxide layer 13 because of deaeration in the metal oxide layer (in the voids of the pores) of the first electrode or reduction in viscosity of the organic solvent-free electrolyte 31. The pressure reduction/temperature conditions are not particularly limited and they may be determined as needed, depending on the specific surface area or porosity of the metal oxide layer 13 or the viscosity of the organic solvent-free electrolyte 31. The degree of vacuum is preferably from about 5×10⁴ to 1×10² Pa and the temperature is preferably from about 20 to 150°C.

The present invention will hereinafter be described in detail by Examples and Comparative Examples. It should however be borne in mind that the invention is not limited to or by them.

### (Example 1)

First, a dye-supported electrode was prepared in the following procedure.
A transparent glass substrate (TCO: manufactured by AGC Fabritech, size: 25 mm long × 25 mm wide × 1.1 mm thick) having fluorine-doped SnO₂ as a transparent conducting film was prepared. Then, 750 ml of a 0.1 M aqueous solution of potassium chloride was prepared as an electrolyte solution. In the resulting electrolyte solution, the transparent conducting film of the transparent glass substrate was disposed so as to face a platinum plate used as a counter electrode. While carrying out bubbling with oxygen by using a silver/silver chloride electrode as a reference electrode, controlled-potential electrolysis (preliminary electrolysis) was performed at a potential of -1.0 V (vs. Ag/AgCl). The electrolysis was performed under the conditions of a temperature of 70°C and a charge quantity of -2.35 C. This preliminary electrolysis is performed with a view to modifying the electrolyte and the surface of the transparent glass substrate by utilizing reduction of dissolved oxygen contained in the electrolyte.
Subsequently, the counter electrode and the electrolyte solution were changed to a zinc plate and 750 ml of a 0.1 M aqueous solution of potassium chloride containing 5 mM of zinc chloride, respectively. Controlled-potential electrolysis was performed at a potential of -1.2 V (vs. Ag/AgCl) while carrying out bubbling with oxygen to precipitate zinc oxide on the transparent conducting film of the transparent glass substrate and form a film as an intermediate layer. That electrolysis was performed under the conditions of a temperature of 70°C and a charge quantity of -0.25 C.
After that, the electrolyte solution was changed to 750 ml of a 0.1 M aqueous solution of potassium chloride containing 5 mM of zinc chloride and 0.18 mM of eosin Y. Controlled-potential electrolysis was performed at a potential of -1.0 V (vs. Ag/AgCl) while carrying out bubbling with oxygen to precipitate eosin Y-loaded zinc oxide porous layer on the intermediate layer. That electrolysis was performed under the conditions of a temperature of 70°C and a charge quantity of -2.0 C.
After washing with water, the resulting electrode was immersed in an aqueous solution of potassium hydroxide having a pH of 11.5 to eliminate eosin Y from the zinc oxide layer. Then, the resulting electrode was washed with water again to obtain a zinc oxide electrode having, on the conductive surface of the base thereof, a porous zinc oxide layer containing a zinc oxide.
The metal oxide electrode thus obtained was dried at 120°C for one hour. Then, the dried electrode was immersed in a sensitizing-dye-containing solution obtained by dissolving 0.25 mM of the below-described sensitizing dye and 0.5 mM of dodecyl cholic acid in a 1:1 mixed solvent of acetonitrile and t-butanol to cause the sensitizing dye to be supported on the surface of zinc oxide. In such a manner, a dye-supported electrode was prepared.

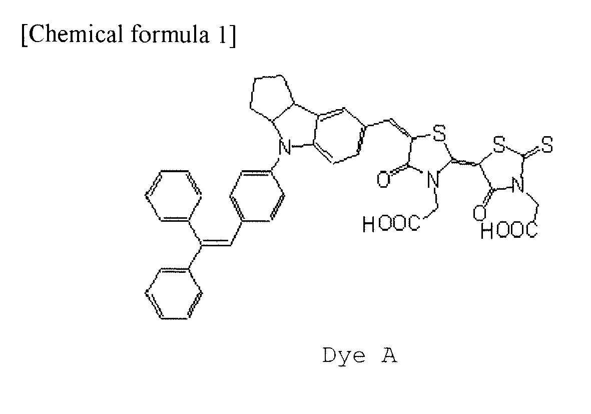

Subsequently, an organic solvent-free electrolyte was prepared in the following manner.
An aqueous solution was prepared by dissolving 0.5 M KI in water. A conductive carbon material ("ECP", trade name of carbon black, product of Lion, specific surface area: 800 m²/g) is added to the resulting aqueous solution. The mixture thus obtained is kneaded in a mortar to obtain an organic solvent-free electrolyte (quasi-solid electrolyte) of Example 1. The composition of the organic solvent-free electrolyte of Example 1 and the mixing ratio of each component are shown in Table 1.

As a counter electrode, a transparent glass substrate (TCO: manufactured by AGC Fabritech, size: 25 mm long × 25 mm wide × 1.1 mm thick) having fluorine-doped SnO₂ as a transparent conducting film was used.

A dye-sensitized solar cell was then fabricated in the following procedure by using the dye-supported electrode, the counter electrode, and the organic solvent-free electrolyte of Example 1 obtained above.
After the dye-supported electrode was placed flat so that the metal oxide layer having a sensitizing dye supported thereon became an upper surface, the edge portion of the metal oxide layer was enclosed with a masking tape and a portion to be filled with the electrolyte was defined. Then, the organic solvent-free electrolyte of Example 1 was applied onto the dye-supported electrode with a spatula to form an electrolyte layer. The counter electrode was placed on the electrolyte layer and fixed with a clip. The electrolyte layer was filled between the dye-supported electrode and the counter electrode to fabricate a dye-sensitized solar cell of Example 1.

The cell characteristics of the dye-sensitized solar cell obtained in Example 1 were measured with a solar simulator at AM-1.5 (1000 W/m²). As the cell characteristics, a short-circuit photoelectric current density (Jsc), an open-circuit voltage (Voc), a fill factor (FF), and a photoelectric conversion efficiency (η) were measured. The measurement results are shown in Table 2. The term "short-circuit photoelectric current density (Jsc)" means, when output terminals of a solar cell module are shortcircuited with each other, an electric current (per 1cm²) flowing between these two terminals. The term "open-circuit voltage (Voc)" means, when the output terminals of the solar cell module are opened, a voltage between these two terminals. The term "fill factor (FF)" means a value (FF=Pmax/Voc·Jsc) determined by dividing the maximum output Pmax by the product of the open-circuit voltage (Voc) and the photoelectric current density (Jsc) and it is a parameter showing the characteristic of the current-voltage characteristic curve of a solar cell. The photoelectric conversion efficiency (η) is a value, in terms of percentage, obtained by dividing, by light intensity per 1 cm², the maximum output, which is a product of a voltage and a current, available by sweeping the voltage of the photoelectric conversion element by using a source meter and measuring a response current and then multiplying the quotient by 100. It is expressed by the following equation: (maximum output)/(optical intensity per 1 cm²)×100.

### (Examples 2 to 5)

In a similar manner to Example 1 except that the inorganic iodine compound was changed to those listed in Table 1, organic solvent-free electrolytes (quasi-solid electrolytes) of Examples 2 to 5 were prepared. Furthermore, in a similar manner to Example 1 except for the use of the organic solvent-free electrolytes of Examples 2 to 5, dye-sensitized solar cells of Examples 2 to 5 were fabricated, respectively. Measurement results are shown in Table 2.

### (Examples 6 and 7)

In a similar manner to Example 1 and Example 3 except for the use of a counter electrode obtained by forming, on the transparent conducting film of the counter electrode used in Example 1, a platinum layer of 100 nm thick by sputtering, dye-sensitized solar cells of Examples 6 and 7 were fabricated, respectively. Measurement results are shown in Table 2.

### (Comparative Examples 1 and 2)

In a similar manner to Example 1 and Example 3 except that the composition and ratios were changed as shown in Table 1, organic solvent-free electrolytes (electrolyte solutions) of Comparative Examples 1 and 2 were prepared, respectively. Furthermore, in a similar manner to Example 1 and Example 3 except for the use of the organic solvent-free electrolytes of Comparative Examples 1 and 2, dye-sensitized solar cells of Comparative Examples 1 and 2 were fabricated, respectively. Measurement results are shown in Table 2.

### (Comparative Examples 3 and 4)

In a similar manner to Comparative Examples 1 and 2 except for the use of a counter electrode obtained by forming, on the transparent conducting films of the counter electrodes used in Comparative Examples 1 and 2, a platinum layer of 100 nm thick by sputtering, dye-sensitized solar cells of Comparative Examples 3 and 4 were fabricated, respectively. Measurement results are shown in Table 2.

**[Table 1]**

| | Counter electrode | Conductive carbon material wt.% | Aqueous solution wt.% | Inorganic iodine compound | | Surface area m²/g |
|---|---|---|---|---|---|---|
| Example 1 | FTO | 20 | 80 | 0.5MKI | | 160 |
| Example 2 | FTO | 20 | 80 | 0.5MKI | 0.25M KIO₃ | 160 |
| Example 3 | FTO | 20 | 80 | 0.5M KI | 0.05M I₂ | 160 |
| Example 4 | FTO | 20 | 80 | 0.5M NaI | | 160 |
| Example 5 | FTO | 20 | 80 | 0.5M MaI | 0.25M NaIO₄ | 160 |
| Example 6 | Pt | 20 | 80 | 0.5MKI | | 160 |
| Example 7 | Pt | 20 | 80 | 0.5MKI | 0.05M I₂ | 160 |
| Comp. Ex. 1 | FTO | 0 | 100 | 0.5MKI | | - |
| Comp. Ex. 2 | FTO | 0 | 100 | 0.5MKI | 0.05M I₂ | - |
| Comp. Ex. 3 | Pt | 0 | 100 | 0.5M KI | | - |
| Comp. Ex. 4 | Pt | 0 | 100 | 0.5M KI | 0.05M I₂ | - |

**[Table 2]**

| | Short-circuit photoelectric current density Jsc (mA·cm⁻²) | Open-circuit voltage Voc (V) | Fill factor ff (%) | Photoelectric conversion efficiency (%) |
|---|---|---|---|---|
| Example 1 | 6.4 | 0.39 | 54 | 1.34 |
| Example 2 | 7.8 | 0.42 | 52 | 1.68 |
| Example 3 | 8.4 | 0.43 | 51 | 1.81 |
| Example 4 | 7.3 | 0.38 | 43 | 1.20 |
| Example 5 | 7.4 | 0.46 | 53 | 1.82 |
| Example 6 | 5.6 | 0.41 | 50 | 1.16 |
| Example 7 | 5.5 | 0.43 | 49 | 1.16 |
| Comp. Ex. 1 | 0.0 | 0.15 | 14 | 0.00 |
| Comp. Ex. 2 | 0.6 | 0.13 | 23 | 0.02 |
| Comp. Ex. 3 | 0.2 | 0.41 | 38 | 0.04 |
| Comp. Ex. 4 | 1.5 | 0.40 | 43 | 0.26 |

### (Examples 8 to 10)

In a similar manner to Example 1 except that the sensitizing dye was changed to those listed below, organic solvent-free electrolytes (quasi-solid electrolytes) of Examples 8 to 10 were prepared. Furthermore, in a similar manner to Example 1 except for the use of the organic solvent-free electrolytes of Examples 8 to 10, dye-sensitized solar cells of Examples 8 to 10 were fabricated, respectively. Measurement results are shown in Table 3.

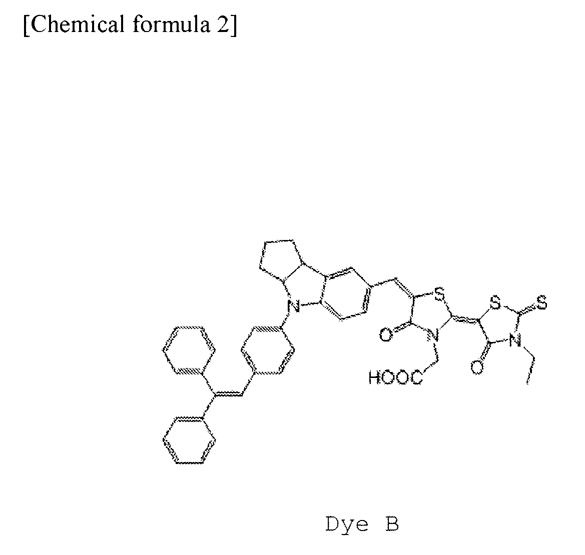

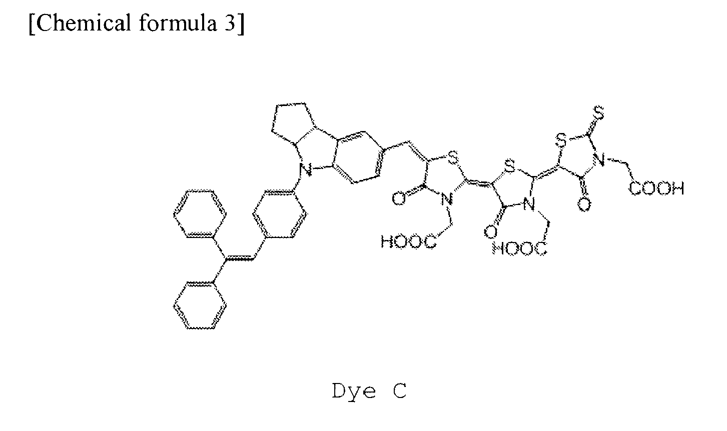

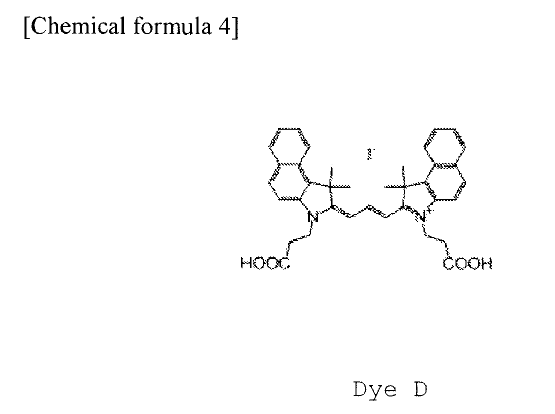

### (Examples 11 and 12)

In a similar manner to Example 3 except that the sensitizing dyes was changed to those listed in Table 3, organic solvent-free electrolytes (quasi-solid electrolytes) of Examples 11 and 12 were prepared. Furthermore, in a similar manner to Example 3 except for the use of the organic solvent-free electrolytes of Examples 11 and 12, dye-sensitized solar cells of Examples 11 and 12 were fabricated, respectively. Measurement results are shown in Table 3.

**[Table 3]**

| | Short-circuit photoelectric current density Jsc (mA·cm⁻²) | Open-circuit voltage Voc (V) | Fill factor ff (%) | Photoelectric conversion efficiency (%) | Sensitizing dye |
|---|---|---|---|---|---|
| Example 8 | 3.8 | 0.41 | 56 | 0.87 | Dye B |
| Example 9 | 5.6 | 0.27 | 46 | 0.69 | Dye C |
| Example 10 | 2.3 | 0.32 | 43 | 0.32 | Dye D |
| Example 11 | 4.1 | 0.42 | 50 | 0.85 | Dye B |
| Example 12 | 2.8 | 0.39 | 44 | 0.48 | Dye D |

### (Examples 13 to 18)

In a similar manner to Example 1 except that the composition and the ratio were changed to those listed in Table 4 and carbon black ("PRINTEX XE 2-B", trade name; product of Degussa, specific surface area: 1000 m²/g) was used as the conductive carbon material, organic solvent-free electrolytes (quasi-solid electrolytes) of Examples 13 to 18 were prepared, respectively. Furthermore, in a similar manner to Example 1 except for the use of the organic solvent-free electrolytes of Examples 13 to 18, dye-sensitized solar cells of Examples 13 to 18 were fabricated, respectively. Measurement results are shown in Table 5.

**[Table 4]**

| | Counter electrode | Conductive carbon material wt.% | Aqueous solution wt.% | Inorganic iodine compound | | Surface area m²/g |
|---|---|---|---|---|---|---|
| Example 13 | FTO | 3 | 97 | 0.5M KI | 0.05M I₂ | 30 |
| Example 14 | FTO | 10 | 90 | 0.5M KI | 0.05M I₂ | 100 |
| Example 15 | FTO | 15 | 85 | 0.5M KI | 0.05M I₂ | 150 |
| Example 16 | FTO | 20 | 80 | 0.5M KI | 0.05M I₂ | 200 |
| Example 17 | FTO | 25 | 75 | 0.5M KI | 0.05M I₂ | 250 |
| Example 18 | FTO | 30 | 70 | 0.5M KI | 0.05M I₂ | 300 |

**[Table 5]**

| | Short-circuit photoelectric current density Jsc (mA·cm⁻²) | Open-circuit voltage Voc (V) | Fill factor ff (%) | Photoelectric conversion efficiency (%) |
|---|---|---|---|---|
| Example 13 | 2.7 | 0.19 | 23 | 0.12 |
| Example 14 | 6.0 | 0.24 | 27 | 0.38 |
| Example 15 | 7.6 | 0.37 | 37 | 1.03 |
| Example 16 | 6.7 | 0.35 | 51 | 1.19 |
| Example 17 | 2.0 | 0.33 | 49 | 0.33 |
| Example 18 | 0.9 | 0.34 | 49 | 0.14 |

As is apparent from Tables 2, 3, and 5, it has been confirmed that the dye-sensitized solar cells obtained in Examples 1 to 18 using the organic solvent-free electrolytes (quasi-solid electrolytes) each containing a conductive carbon material, water, and an inorganic iodine compound generate electric power and have an excellent photoelectric conversion efficiency. It has been confirmed, on the other hand, that the dye-sensitized solar cells obtained in Comparative Examples 1 and 2 do not generate electric power at all or have a remarkably low photoelectric conversion efficiency. In addition, it has been confirmed that the dye-sensitized solar cells of Comparative Examples 3 and 4 using platinum as the counter electrode have also a remarkably low photoelectric conversion efficiency.
These findings suggest that organic solvent-free electrolytes (quasi-solid electrolytes) each containing a conductive carbon material, water, and an inorganic iodine compound exhibit excellent photoelectric conversion characteristics as an aqueous electrolyte not containing an organic solvent. In addition, although such organic solvent-free electrolytes are water-based electrolytes not containing an organic solvent, they can be used in a quasi-solid form so that they can be released from the problems such as leakage of the solvent and also environmental pollution, fire or explosion due to the leakage.

Furthermore, it has been confirmed that the dye-sensitized solar cells obtained in Comparative Examples 3 and 4 have, because they use platinum as a counter electrode, an improved photoelectric conversion efficiency compared with those obtained in Comparative Examples 1 and 2. It has been confirmed, on the other hand, that as is apparent from the comparison between Example 1 and Example 6 and between Example 3 and Example 7, the organic solvent-free electrolytes (quasi-solid electrolytes) containing a conductive carbon material, water, and an inorganic iodine compound exhibit an excellent photoelectric conversion efficiency in the constitution not using platinum as the counter electrode.
It has been confirmed from the above-described findings that organic solvent-free electrolytes (quasi-solid electrolytes) containing a conductive carbon material, water, and an inorganic iodine compound exhibit particularly excellent photoelectric conversion characteristics in the constitution not using platinum as a counter electrode. Details of the mechanism of action of such a peculiar result have not been elucidated yet, but the conductive carbon material contained in the organic solvent-free electrolyte is presumed to assume a catalytic action and conductivity instead of conventionally used platinum. The action is not however limited to it.

As described above, the present invention is not limited to the above-described embodiments and examples. Modifications can be made as needed without departing from the scope of the invention.

### Industrial Applicability

As described above, the present invention can be utilized widely and effectively in electronic/electric materials and electronic/electric devices related to dye-sensitized solar cells, and various instruments, equipment, and systems equipped therewith.

The present application is based on Japanese priority applications No. 2009-129430 filed on May 28, 2009, the entire contents of which are hereby incorporated by reference.

### Description of Numerical References

- 11:: dye-supported electrode
- 12:: base
- 12a:: conductive surface
- 13:: metal oxide layer
- 14:: metal oxide electrode
- 21:: counter electrode
- 22a:: conductive surface
- 22:: base
- 31:: organic solvent-free electrolyte
- 41:: spacer
- 100:: dye-sensitized solar cell

## Claims

1. A dye-sensitized solar cell comprising:
a metal oxide electrode having a base and a metal oxide layer disposed on the base,
a counter electrode disposed so as to face the metal oxide electrode, and
an electrolyte placed between the metal oxide electrode and the counter electrode;
wherein the metal oxide layer comprises a sensitizing dye supported thereon;
and the electrolyte is an organic solvent-free electrolyte containing a conductive carbon material, water, and an inorganic iodine compound.

2. The dye-sensitized solar cell according to Claim 1,
wherein the organic solvent-free electrolyte is a quasi-solid electrolyte.

3. The dye-sensitized solar cell according to Claim 1 or 2,
wherein the surface area of the conductive carbon material in the organic solvent-free electrolyte is from 30 to 300 m²/g.

4. An organic solvent-free electrolyte for dye-sensitized solar cell, comprising a conductive carbon material,
water, and
an inorganic iodine compound.
